# EUROPÄISCHE PATENTSCHRIFT

(11) **EP 0 554 300 B1**
(45) Veröffentlichungstag und Bekanntmachung des Hinweises auf die Patenterteilung: **12.06.1996**
(21) Anmeldenummer: 91918294.9
(22) Anmeldetag: 15.10.1991
(51) Int. Cl.: H03M 7/30, G11B 20/12, H04N 7/24

(54) **VERFAHREN, CODER UND DECODER ZUR DATENÜBERTRAGUNG UND/ODER -SPEICHERUNG**
PROCESS, CODER AND DECODER FOR DATA TRANSMISSION AND/OR STORAGE
PROCEDE, CODEUR ET DECODEUR DE TRANSMISSION ET/OU D'ENREGISTREMENT DE DONNEES

(30) Priorität: 24.10.1990 DE 4033815
(43) Veröffentlichungstag der Anmeldung: 11.08.1993
(73) Patentinhaber: DEUTSCHE THOMSON-BRANDT GMBH, D-78048 Villingen-Schwenningen (DE)
(72) Erfinder: KEESEN, Heinz-Werner, D-3000 Hannover 1 (DE); SCHÜTZE, Herbert, D-3100 Celle (DE); HAUPT, Dieter, D-3257 Springe 6 (DE)
(74) Vertreter: Hartnack, Wolfgang, Dipl.-Ing.
(86) Internationale Anmeldenummer: EP9101954
(87) Internationale Veröffentlichungsnummer: WO9208289

(56) Entgegenhaltungen:
- EP-A- 0 385 654
- DE-A- 3 702 490
- DE-A- 3 736 898

## Beschreibung

Die Erfindung betrifft ein Verfahren, einen Coder und einen Decoder zur Datenübertragung und/oder -speicherung.

### Stand der Technik

In DE-A-3702490 wird ein Verfahren zur Datenübertragung beschrieben, bei dem Daten von Bildpunkt-Blöcken in Digitalsignale aus einer DCT (discrete cosine transform) umgesetzt werden, die mit variabler Wortlänge codiert sind. Dabei werden die Digitalsignale in Blöcken mit einer mittleren Länge aufgezeichnet. Nicht ausgefüllte Blöcke werden mit Daten von anderen Blöcken aufgefüllt. Um die Störempfindlichkeit zu verbessern, werden Gleichanteile und wichtige Wechselanteile in festen Abständen aufgezeichnet. Wenn Fehler auf dem Übertragungskanal bzw. Speichermedium aufgetreten sind, können jedoch die auf andere Blöcke verteilten Daten eines Blocks nicht decodiert werden. EP-A-0385654 zeigt ein Format für Datensignale unterschiedlicher Länge, bei dem alle (Unter-) Blöcke die gleiche Länge haben. Es werden folgende Steuerdaten mitübertragen: eine 4 Bit-Adresse, die angibt, daß Daten des i-ten (Unter-) Blocks folgen, und ein Nibble, welches die Anzahl der Daten im i-ten (Unter-) Block angibt.

### Erfindung

Der Erfindung liegt die Aufgabe zugrunde, ein verbessertes Verfahren zur Datenübertragung und/oder -speicherung anzugeben, bei dem im Fehlerfall auch die Decodierung von auf andere Blöcke verteilten Daten ermöglicht wird. Diese Aufgabe wird durch das in Anspruch 1 angegebene erfindungsgemäße Verfahren gelöst.

Im Prinzip besteht das erfindungsgemäße Verfahren darin, daß bei einer Datenübertragung und/oder -speicherung coderseitig Daten zunächst abschnittsweise in Digitalsignale mit unterschiedlicher Wortlänge (lₙ) umgesetzt und danach unter Verwendung von ersten Speichern (3, 4) Blöcken konstanter, mittlerer Wortlänge (m) zugewiesen werden, wobei ausgewählte Daten-Anteile, insbesondere ein Gleichanteil (DC) und die wichtigsten Wechselanteile (ACₙ) mit ihren zugehörigen Adressen, aus den Abschnitten der Digitalsignale in jedem dieser Blökke angeordnet sind und wobei anschließend Blöcke mit einer geringeren als der mittleren Wortlänge mit abgeteilten Daten-Anteilen (ACₓ) von Blöcken mit einer größeren als der mittleren Wortlänge aufgefüllt werden und decoderseitig die Blöcke unter Verwendung von zweiten Speichern (9, 10) in ihrer ursprünglichen, unterschiedlichen Wortlänge (lₙ) wiedergewonnen werden, und wobei jeder der Blöcke zusätzlich ein Adressinformations-Flag (FL) und eine Adresspointer-Information (POI) enthält, die nach Übertragungs- und/oder Lesefehlern bei der Decodierung auf Adressen in den zweiten (9, 10) Speichern hinweisen, aus denen die abgeteilten Daten-Anteile (ACₓ) von Blöcken mit einer größeren als der mittleren Wortlänge wiedergewonnen und zur Decodierung genutzt werden können.
Dabei können die Digitalsignale codierte Koeffizienten einer DCT und die Blöcke konstanter, mittlerer Wortlänge eine Information (I) darüber enthalten, welche Art von DCT-Koeffizienten in den Digitalsignalen für den jeweiligen Block enthalten sind.
Mit dem Adressinformations-Flag (FL) werden Blöcke mit oder ohne Wechselanteile von anderen Blöcken entsprechend markiert.

Vorteilhafte Weiterbildungen des erfindungsgemäßen Verfahrens ergeben sich aus den zugehörigen Unteransprüchen.

Der Erfindung liegt die weitere Aufgabe zugrunde, einen Coder für das erfindungsgemäße Verfahren anzugeben. Diese Aufgabe wird durch die in Anspruch 6 angegebene erfindungsgemäße Einrichtung gelöst.

Im Prinzip ist der erfindungsgemäße Coder versehen mit einer Codierschaltung (1), die Daten abschnittsweise in Digitalsignale mit unterschiedlicher Wortlänge (lₙ) umgesetzt, mit einem nachgeschalteten Multiplexer (2), der unter Verwendung von nachgeschalteten ersten Speichermitteln (3, 4) Blöcke konstanter, mittlerer Wortlänge (m) bildet, wobei ausgewählte Daten-Anteile, insbesondere ein Gleichanteil (DC) und die wichtigsten Wechselanteile (ACₙ) mit ihren zugehörigen Adressen, aus den Abschnitten der Digitalsignale für jeden dieser Blöcke in den ersten Speichermitteln gespeichert werden und Blöcke mit einer geringeren als der mittleren Wortlänge mit abgeteilten Daten-Anteilen (ACₓ) von Blöcken mit einer größeren als der mittleren Wortlänge aufgefüllt werden, mit einem den Speichermitteln nachgeschalteten Demultiplexer (5), der die zu einem jeweiligen Block zugehörenden Daten bündelt und zu einem Kanal (6) weiterleitet, mit einer von den ersten Speichermitteln gespeisten Schaltung zur Adresspointer-Berechnung (13), die den Multiplexer und den Demultiplexer steuert und den ersten Speichermitteln für jeden Block ein Adressinformations-Flag (FL) und Adresspointer-Information (POI) zuführt.

Der Erfindung liegt die weitere Aufgabe zugrunde, einen Decoder für das erfindungsgemäße Verfahren anzugeben. Diese Aufgabe wird durch die in Anspruch 7 angegebene erfindungsgemäße Einrichtung gelöst.

Im Prinzip ist der erfindungsgemäße Decoder versehen mit einer einem Kanal (6) nachgeschalteten Adresspointer-Decodierschaltung (7) zur Abtrennung und Weiterleitung von Adresspointer-Informationen und Adressinformations-Flags (FL) an eine Schaltung zur Adresspointer-Berechnung 14, mit einem der Adresspointer-Decodierschaltung nachgeschalteten Multiplexer (8), der zusammen mit nachgeschalteten zweiten Speichermitteln (9, 10) Daten-Blöcke in ihrer ursprünglichen, unterschiedlichen Wortlänge (lₙ) wiedergewinnt, mit einem nachgeschalteten Demultiplexer (11), der die zu einem jeweiligen Block zugehörenden Daten bündelt und zu einem Variable-length-Decoder (12) weiterleitet, an dessen Ausgang den Quell-Daten bei der Codierung entsprechende Daten zur Verfügung stehen, wobei die Schaltung zur Adresspointer-Berechnung (14) den Multiplexer und den Demultiplexer steuert und den zweiten Speichermitteln für jeden Block Adresspointer-Informationen (POI) zuführt.

Durch bekannte Verfahren der adaptiven Ouantisierung wird erreicht, daß Blöcke von Bildpunkt-Daten im Mittel eine Länge von m Bit erhalten. Diese durchschnittliche Anzahl von m Bits wird mittlere Blocklänge genannt. Die Blöcke werden bei der Übertragung bzw. Aufzeichnung so angeordnet, daß die Blockanfänge im festen Abstand (Raster) der mittleren Blocklänge m liegen.
Jedem Block wird an einer festgelegten Stelle außer einem Gleichspannungsanteil ein Adressinformations-Flag und eine Adresspointer-Information zugefügt.
Mit Hilfe dieser Zusatzinformation kann im Fehlerfall eine verbesserte Resynchronisation durchgeführt werden, bei der auch die auf andere Blöcke verteilten Wechselanteile decodiert werden können.

### Zeichnungen

Anhand der Zeichnungen werden Ausführungsbeispiele der Erfindung beschrieben. Die Zeichnungen zeigen in:
- Fig. 1: Daten aus einer blockorientierten DCT-Codierung mit variabler Wortlänge (bekannt);
- Fig. 2: erfindungsgemäßer Übertragungsdaten-Block;
- Fig. 3: erfindungsgemäßer Übertragungsdaten-Block für einen Block mit geringer Codierungs-Datenmenge;
- Fig. 4: Blockschaltbild für einen erfindungsgemäßen Coder und Decoder;
- Fig. 5: DCT-Datenblöcke als Eingangsdaten für die Coderschaltung 1;
- Fig. 6: Daten in Dualport-RAM_{FIX} 3;
- Fig. 7: Daten in Dualport-RAM_{VAR} 4;
- Fig. 8: Daten in Dualport-RAM_{VAR} 10;
- Fig. 9: Kanal-Information;
- Fig. 10: Kanal-Information im Fehlerfall;
- Fig. 11: Daten in Dualport-RAM_{VAR} 4 im Fehlerfall;
- Fig. 12: Daten in Dualport-RAM_{VAR} 10 im Fehlerfall;
- Fig. 13: DCT-Datenblöcke als Eingangsdaten für Codierschaltung 1 im Fehlerfall.

### Ausführungsbeispiele

Bei einer Begrenzung der Übertragungs- bzw. Aufzeichnungskapazität auf eine mittlere Informationsdichte durch zeitliche Kompression und anschließende Expansion, also durch unterschiedliche Wortlänge der Datenabschnitte in Abhängigkeit der Informationsdichte, ergibt sich das Problem, die unterschiedlich langen Datenabschnitte nach der Übertragung bzw. Aufzeichnung wiederzuerkennen. Diese Wiedererkennung wird besonders dann schwierig, wenn Störungen die Wiedererkennungskriterien beseitigen. Es kann dann der Fall eintreten, daß auch nach Abklingen der Störung eine richtige Erkennung der nachfolgenden Datenabschnitte vereitelt ist.
Die zeitliche Kompression und Expansion der Datenabschnitte wird darum kombiniert mit einem festen Zeitraster, indem Blöcke, deren Kapazität durch die zugewiesenen Datenabschnitte nicht ausgeschöpft ist, durch andere Datenabschnitte aufgefüllt und besser ausgenutzt werden. So wird zum einen die Vollständigkeit der Daten gewährleistet, zum anderen wird durch das Zeitraster ermöglicht, die Datenabschnitte durch die Zuweisung zu den Blöcken wiederzuerkennen. Der Einfluß von Störungen wird somit reduziert.

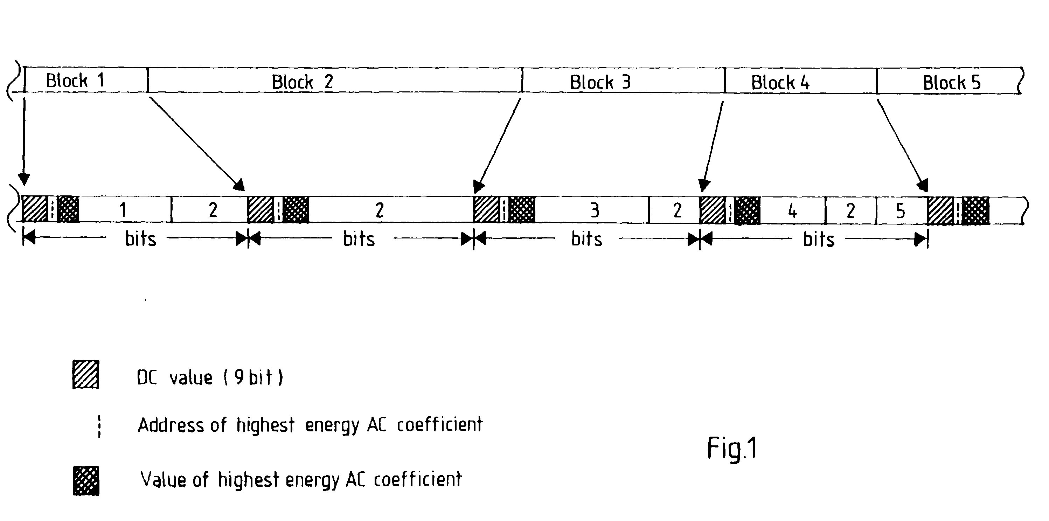

In Fig. 1 sind schematisch Block-Daten dargestellt. Im oberen Teil der Figur sind Blöcke mit Daten unterschiedlicher Länge dargestellt. Im unteren Teil der Figur haben die Blökke eine festgelegte Länge und enthalten jeweils zu Beginn einen Gleichspannungsanteil 'DC value', die Adresse für den größten Wechselanteil 'Address of highest energy AC coefficient' innerhalb des zugehörigen Blocks und diesen größten Wechselanteil 'Value of highest energy AC coefficient' selbst, sowie weitere wichtige Wechselanteile und ihre zugehörigen Adressen. Die Zahlen geben jeweils an, aus welchem Block aus der oberen Hälfte die restlichen Wechselanteile stammen.
Es können auch mehrere Blöcke zu einem Rahmen zusammengefaßt und innerhalb dieses Rahmens die Datenabschnitte vor der Auffüllung der Blöcke in der Summe ihrer Wortlängen mit der Summe der Wortlängen der Blöcke in Übereinstimmung gebracht werden. Diese Übereinstimmung kann in einer Vergrößerung oder Verkleinerung der originären Wortlängen der Datenabschnitte bestehen. Dabei ist die Summe der Wort längen der Datenabschnitte höchstens gleich der Summe der Wortlängen der Blökke, damit die zur Verfügung stehende Wortlänge der Blöcke optimal ausgenutzt werden kann und keine wichtige Information verloren geht.

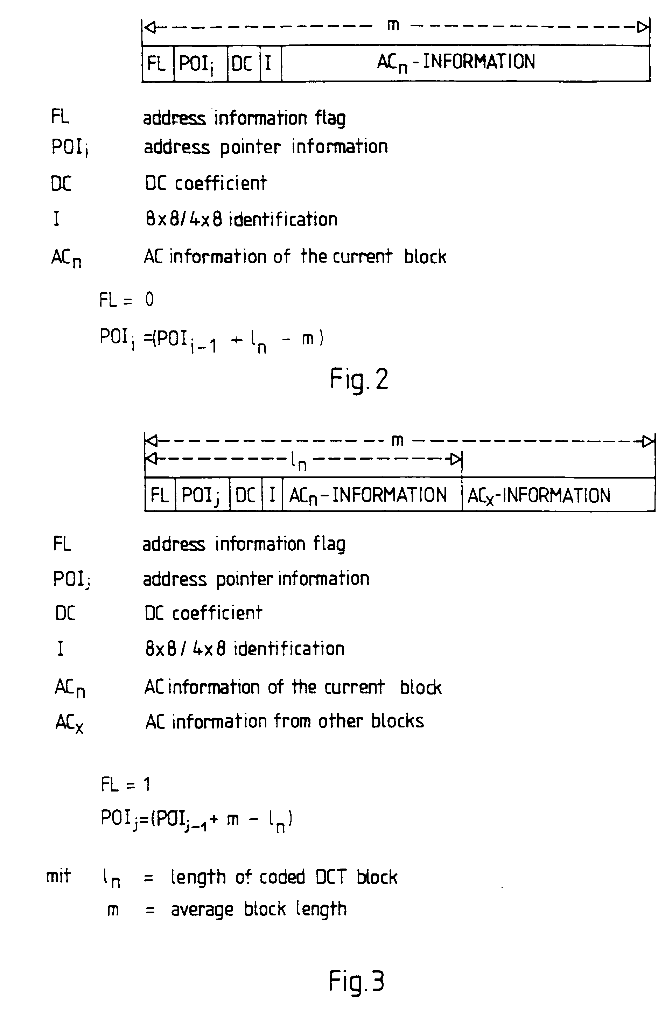

Beim erfindungsgemäßen Verfahren nach Fig. 2 und Fig. 3 werden jedem Block Zusatzinformationen hinzugefügt, um die coderseitig vorhandene Blockstruktur auch im Fehlerfall decodieren zu können. Außer dem Gleichanteil DC und den informationen über die zugehörigen Wechselanteile ACₙ enthält jeder Block n zusätzlich ein Adressinformations-Flag FL und eine Adresspointer-Information POI. Zusätzlich kann ein Identifikations-Flag I angeben, ob der Block mit einer 8*8-DCT oder mit einer doppelten 4*8-DCT codiert wurde. Eine 8*8-DCT wird vorteilhaft bei statischem Bildinhalt verwendet und eine 2*(4*8)-DCT bei dynamischem Bildinhalt in Interlace-Bildsignalen.
Für Blöcke, bei denen die erforderliche Datenmenge die mittlere Blocklänge m überschreitet, gilt Fig. 2. Bei diesen Blöcken wird das Adressinformations-Flag FL auf 'O' gesetzt. Die Adresspointer-Infcrmation POIᵢ für den aktuellen Block wird jeweils aus der Adresspointer-Information POIᵢ₋₁, des vorhergehenden Blocks mit FL = 0 berechnet, indem die Länge Iₙ des codierten Blocks n hinzuaddiert und die mittlere Blocklänge m subtrahiert wird. Anschließend wird Index i um '1' inkrementiert.

Blöcke, die kürzer oder gleich der mittleren Blocklänge m sind bzw. Wechselanteile ACₓ von einem oder mehreren anderen Blöcken enthalten, erhalten einen Aufbau nach Fig. 3. Bei diesen Blöcken wird das Adressinformations-Flag FL auf '1' gesetzt. Die Adresspointer-Information POIⱼ für den aktuellen Block wird jeweils aus der Adresspointer-Information POIⱼ₋₁ des vorhergehenden Blocks mit FL = 1 berechnet, indem die mittlere Blocklänge m hinzuaddiert und die Länge lₙ des codierten Blocks n subtrahiert wird. Anschließend wird Index j um '1' inkrementiert.
Die mittlere Blocklänge m hängt von der Kapazität des Kanals ab. FL, POI, DC und I haben in diesem Kanal jeweils eine feste Bitlänge. Es können z.B. folgende Bitlängen verwendet werden:
FL: 1, POI: 9, DC: 9, I: 1.

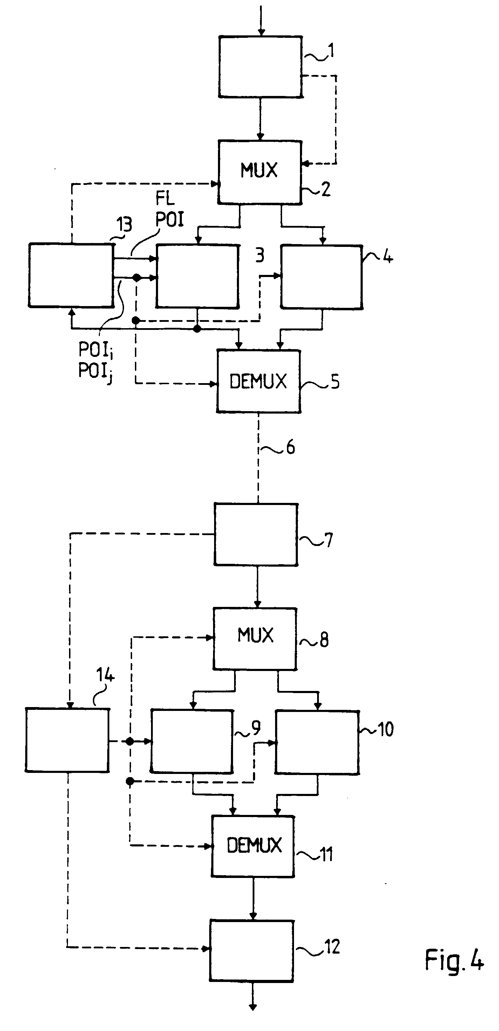

Fig. 4 zeigt ein Coder- und Decoder-Blockschaltbild mit dem die erfindungsgemäße Übertragung bzw. Speicherung realisiert werden kann. In einer Codierschaltung 1 werden z.B. DCT-transformierte Bilddaten quantisiert, Huffman-codiert und mit Adressen für Wechselanteile versehen. Je nach sich ergebender Blocklänge teilt ein nachgeschalteter Multiplexer 2 die Blockdaten auf die nachfolgenden Dualport-RAM's 3 und 4 auf. Das Adressinformations-Flag FL und die Adresspointer-Information POI werden von einer Schaltung zur Adresspointer-Berechnung 13 in ein Dualport-RAM_{FIX} 3 als Dateninformation für jeden Block mit eingeschrieben. Die Adresspointer-Information POI kann zusätzlich als Adressinformation für das Dualport-RAM_{VAR} 4 angesehen werden. Der Index FIX bezeichnet feststehende Daten und der Index VAR die restlichen Wechselanteile. Das Adressinformations-Flag FL zeigt an, ob der übertragene Block länger oder kürzer als die mittlere Blocklänge m ist. POIᵢ gibt bei Blöcken, die länger als m sind, an, bis zu welcher Adresse das Dualport-RAM_{VAR} 4 mit Daten beschrieben worden ist. POIⱼ gibt bei Blöcken, die kürzer als m sind, an, bis zu welcher Adresse Daten, die zu anderen Blöcken gehören, aus dem Dualport-RAM_{VAR} 4 ausgelesen werden. In einem sich an die Dualport-RAM's anschließenden Demultiplexer 5 werden die Daten wieder zusammengeführt und auf den Kanal 6 gegeben.

Mit den Informationen, die ein Adresspointer-Decodierschaltung 7 decodiert hat, kann eine Schaltung zur Adresspointer-Berechnung 14 die notwendigen Adressinformationen für ein Dualport-RAM_{VAR} 10 zur Verfügung stellen. Das Adressinformations-Flag FL signalisiert, ob der aktuell übertragene Block kürzer oder länger als die mittlere Blocklänge m ist. POIᵢ gibt decoderseitig die Adresse an, bis zu welcher Daten aus dem Dualport-RAM_{VAR} 10 in Richtung Variable-length-Decoder 12 ausgelesen werden, der eine zur coderseitigen Codierschaltung 1 entsprechend inverse Funktion hat. POIⱼ zeigt, bis zu welcher Adresse Daten in das Dualport-RAM_{VAR} 10 geschrieben werden.
Entsprechend dem Coderteil ist ebenfalls ein DualportRAM_{FIX} 9 im Decoderteil zwischen dem Multiplexer und dem Demultiplexer angeordnet. Zwischen diesen RAM's und dem Adresspointer-Decoder ist ein entsprechender Multiplexer 8 und zwischen diesen RAM's und dem Variable-length-Decoder ist ein entsprechender Demultiplexer 11 angeordnet. Statt Dualport-RAM's können auch andere Speicher verwendet werden.

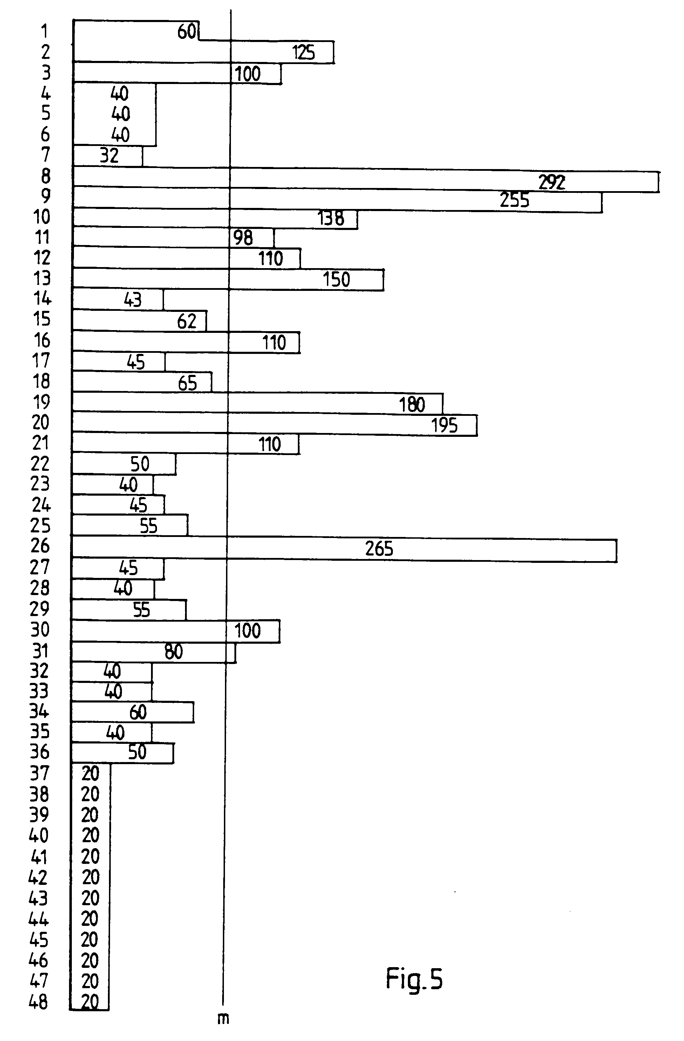

Fig. 5 zeigt 48 DCT-Datenblöcke als Eingangsdaten für Codierschaltung 1. Es ist jeweils die tatsächliche Wortlänge angegeben und die mittlere Wortlänge m markiert.

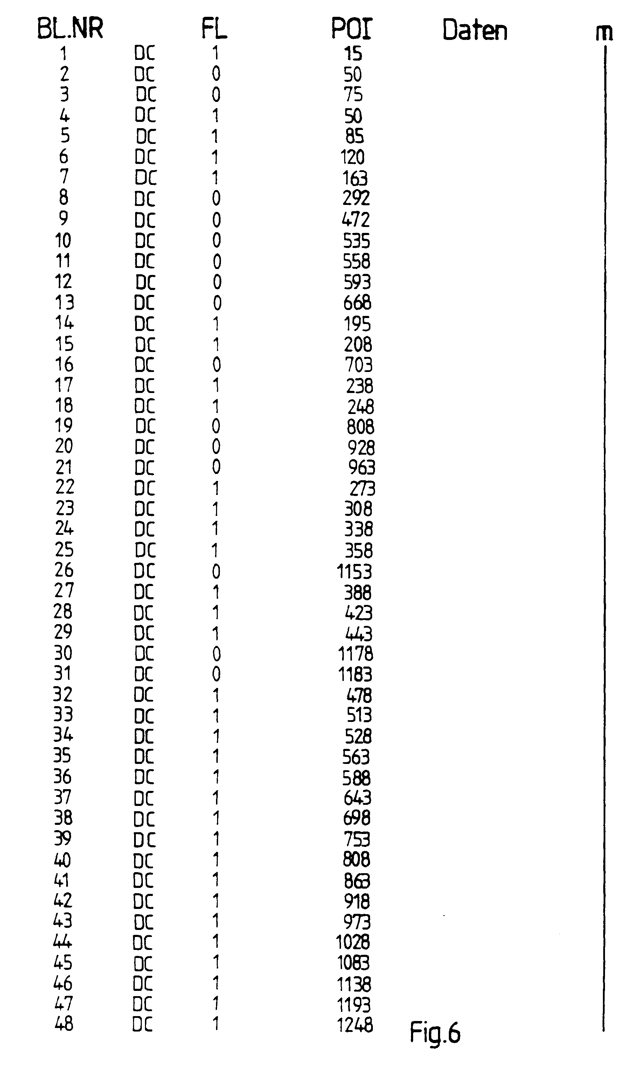

Fig. 6 zeigt den resultierenden Dateninhalt von DualportRAM_{FIX} 3 mit den jeweiligen Werten für n, FL und POI.

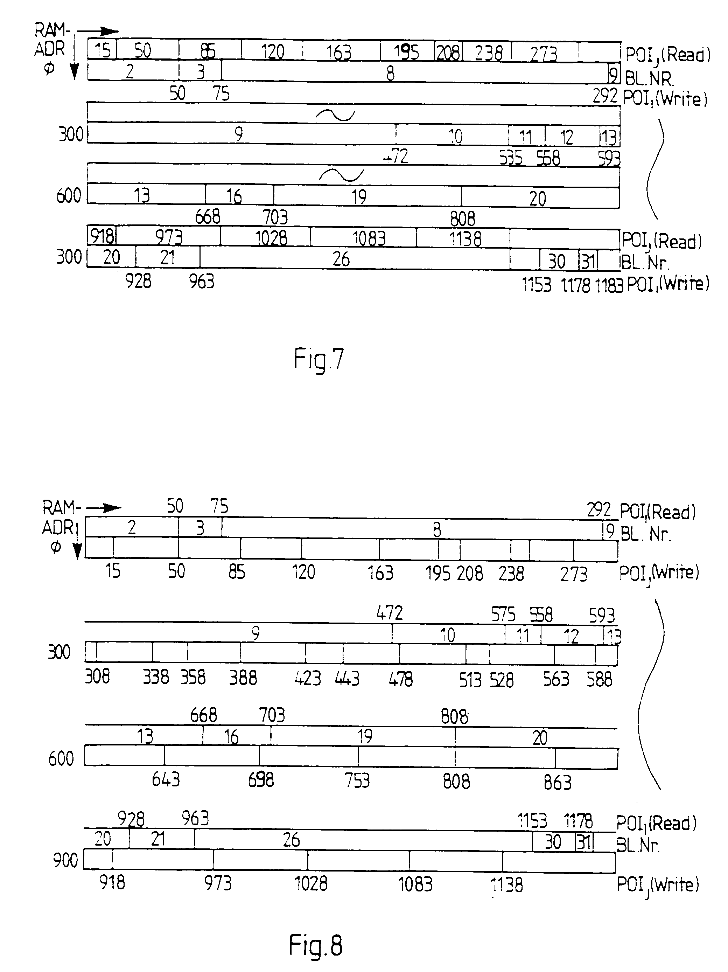

Fig. 7 zeigt den Inhalt von Dualport-RAM_{VAR} 4 im Coderteil. Über der RAM-Adresse sind POIⱼ für das Lesen, die Blocknummer n und POIᵢ für das Schreiben aufgetragen.

Fig. 8 zeigt den Inhalt von Dualport-RAM_{VAR} 10 im Decoderteil. Über der RAM-Adresse sind POIᵢ für das Lesen, die Blocknummer n und POIⱼ für das Schreiben aufgetragen.

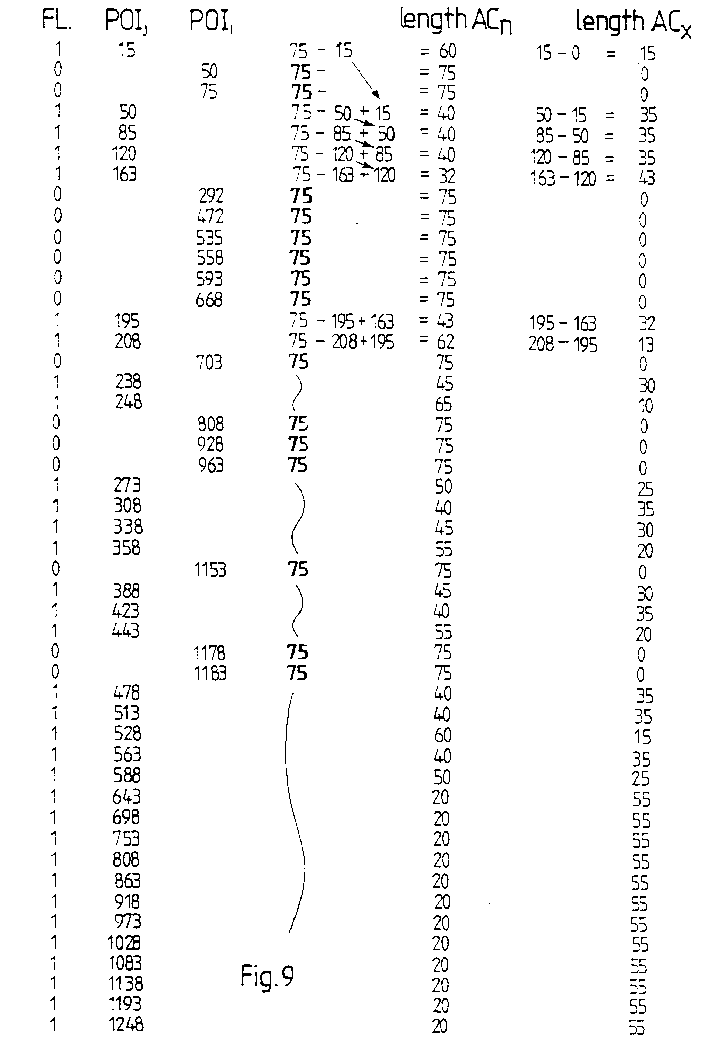

Fig. 9 zeigt die resultierende Kanalinformation von Kanal 6 mit den Werten für FL, POIⱼ, POIᵢ, Länge der ACₙ- und der ACₓ-Wechselanteile.

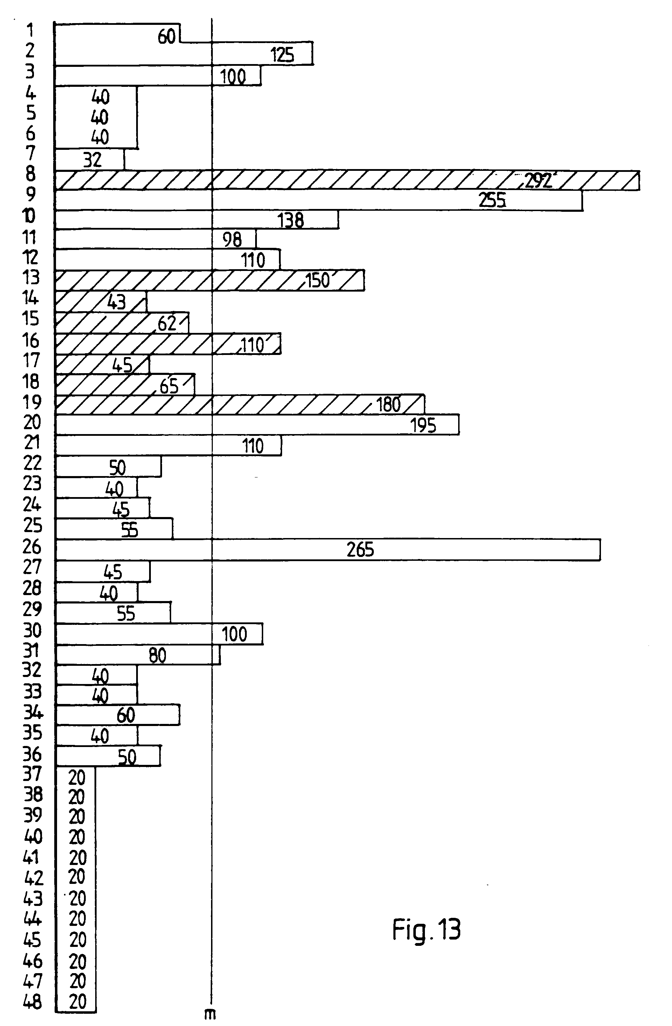

Fig. 13 zeigt die 48 DCT-Datenblöcke aus Fig. 5, jedoch im Fehlerfall. Es ist wieder jeweils die tatsächliche Wortlänge angegeben und die mittlere Wortlänge m markiert. Fehlerhaft übertragene bzw. gelesene Blöcke sind schraffiert.

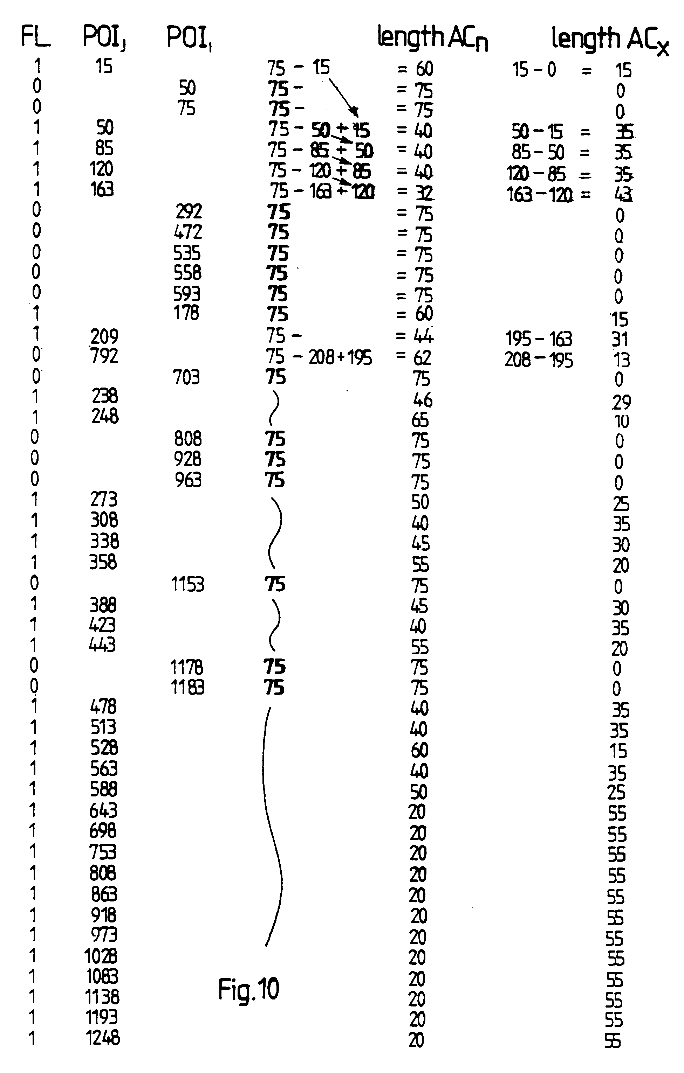

Fig. 10 zeigt die Fig. 9 entsprechende Darstellung im Fehlerfall. Entsprechende geänderte Werte stehen neben durchkreuzten Werten für den fehlerfreien Fall.

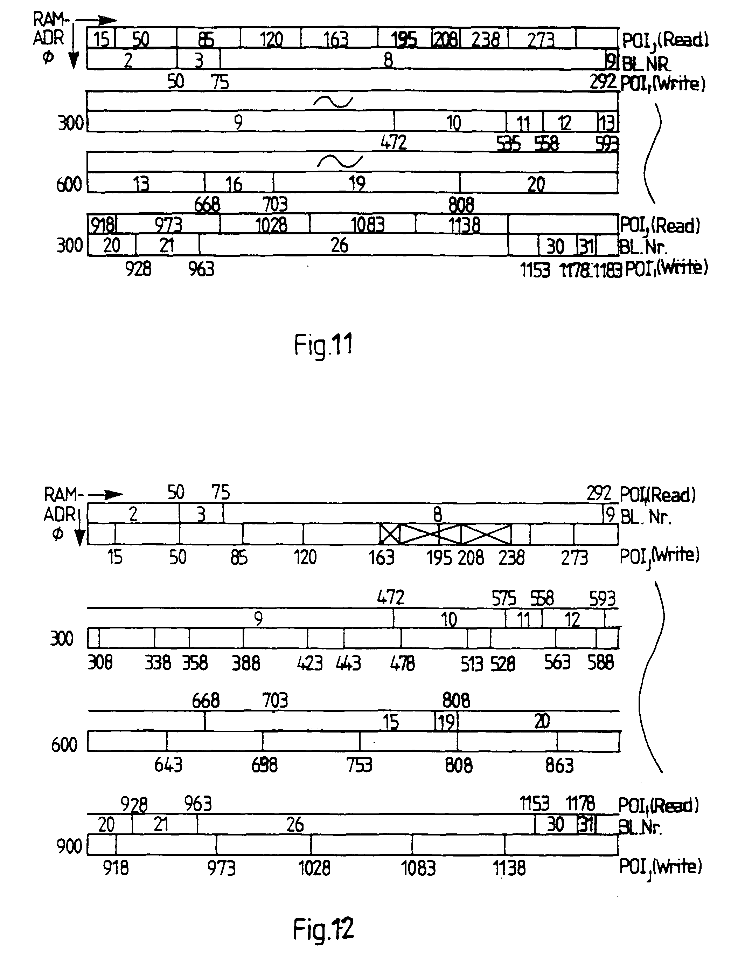

Fig. 11 bzw. Fig. 12 zeigen die den Verhältnissen in Fig. 7 bzw. Fig. 8 entsprechenden Werte für den Fehlerfall. Fehlerorte sind durchkreuzt. Weil Fehler erst nach der Codierung auftreten, enthalten Fig. 7 und Fig. 11 die gleichen Werte.

## Patentansprüche

1. Verfahren zur Datenübertragung und/oder -speicherung, bei dem coderseitig Daten zunächst abschnittsweise in Digitalsignale mit unterschiedlicher Wortlänge (lₙ) umgesetzt und danach unter Verwendung von ersten Speichern (3, 4) Blöcken konstanter, mittlerer Wortlänge (m) zugewiesen werden, wobei ausgewählte Daten-Anteile, insbesondere ein Gleichanteil (DC) und die wichtigsten Wechselanteile (ACₙ) mit ihren zugehörigen Adressen, aus den Abschnitten der Digitalsignale in jedem dieser Blöcke angeordnet sind und wobei auschließend Blöcke mit einer geringeren als der mittleren Wortlänge mit abgeteilten Daten-Anteilen (ACₓ) von Blöcken mit einer größeren als der mittleren Wortlänge aufgefüllt werden und decoderseitig die Blöcke unter Verwendung von zweiten Speichern (9, 10) in ihrer ursprünglichen, unterschiedlichen Wortlänge (lₙ) wiedergewonnen werden, da**durch gekennzeichnet,** daß jeder der Blöcke zusätzlich ein Adressinformations-Flag (FL) und eine Adresspointer-Information (POI) enthält, die nach Übertragungs- und/oder Lesefehlern bei der Decodierung auf Adressen in den zweiten (9, 10) Speichern hinweisen, aus denen die abgeteilten Daten-Anteile (ACₓ) von Blökken mit einer größeren als der mittleren Wortlänge wiedergewonnen und zur Decodierung genutzt werden können.

2. Verfahren nach Anspruch 1, **dadurch gekennzeichnet,** daß die Digitalsignale codierte Koeffizienten einer DCT enthalten.

3. Verfahren nach Anspruch 2, **dadurch gekennzeichnet,** daß die Blöcke konstanter, mittlerer Wortlänge eine Information (I) darüber enthalten, welche Art von DCT-Koeffizienten in den Digitalsignalen für den jeweiligen Block enthalten sind.

4. Verfahren nach einem oder mehreren der Anspriiche 1 bis 3, **dadurch gekennzeichnet,** daß mit dem Adressinformations-Flag (FL) Blöcke mit oder ohne Wechselanteile von anderen Blöcken entsprechend markiert werden.

5. Verfahren nach einem oder mehreren der Ansprüche 1 bis 4, **dadurch gekennzeichnet,** daß Blöcke mit oder ohne Wechselanteile von anderen Blöcken entsprechend getrennt berechnete Adresspointer-Informationen (POIᵢ, POIⱼ) enthalten, wobei die Indices (i, j) dieser getrennten Adresspointer-Informationen jeweile bei der Codierung einer entsprechenden Art von Block um den Wert '1' inkrementiert werden.

6. Coder für ein Verfahren nach einem oder mehreren der Ansprüche 1 bis 5, der enthält:
- eine Codierschaltung (1), die Daten abschnittsweise in Digitalsignale mit unterschiedlicher Wortlänge (lₙ) umsetzt;
- einen nachgeschalteten Multiplexer (2), der mittels nachgeschalteter erster Speichermittel (3, 4) Blöcke konstanter, mittlerer Wortlänge (m) bildet, wobei ausgewählte Daten-Anteile - insbesondere ein Gleichanteil (DC) und die wichtigsten Wechselanteile (ACₙ) mit ihren zugehörigen Adressen - aus den Abschnitten der Digitalsignale für jeden dieser Blöcke in den ersten Speichermitteln gespeichert werden und Blöcke mit einer geringeren als der mittleren Wortlänge mit abgeteilten Daten-Anteilen (ACₓ) von Blöcken mit einer größeren als der mittleren Wortlänge aufgefüllt werden;
- einen den Speichermitteln nachgeschalteten Demultiplexer (5), der die zu einem jeweiligen Block zugehörenden Daten bündelt und zu einem Datenkanal (6) weiterleitet,
**gekennzeichnet durch:**
- eine von den ersten Speichermitteln gespeiste Schaltung zur Adresspointer-Berechnung (13), die den Multiplexer und den Demultiplexer steuert und den ersten Speichermitteln für jeden Block ein Adressinformations-Flag (FL) und Adresspointer-Information (POI) zuführt.

7. Decoder für ein Verfahren nach einem oder mehreren der Ansprüche 1 bis 5, der enthält:
- eine einem Datenkanal (6) nachgeschaltete Decodierschaltung (7) zur Abtrennung von Block-Daten;
- einen nachgeschalteten Multiplexer (8), der zusammen mit nachgeschalteten Speichermitteln (9, 10) Daten-Blökke in ihrer ursprünglichen, unterschiedlichen Wortlänge (lₙ) wiedergewinnt;
- einen den Speichermitteln nachgeschalteten Demultiplexer (11), der die zu einem jeweiligen Block zugehörenden Daten bündelt und zu einem Variable-length-Decoder (12) weiterleitet, an dessen Ausgang den Quell-Daten bei der Codierung entsprechende Daten zur Verfügung stehen,
**gekennzeichnet durch**:
- eine Schaltung zur Adresspointer-Berechnung (14), die den Multiplexer und den Demultiplexer steuert und den Speichermitteln für jeden Block Adresspointer-Informationen (POI) zuführt, wobei die Decodierschaltung (7) aus dem ankommenden Datenstrom Adresspointer decodiert und Adresspointer-Informationen und AdressinformationsFlags (FL) an die Schaltung zur Adresspointer-Berechnung (14) weiterleitet.

## Claims

1. Method of transferring and/or storing data in which, at the coder end, items of data are initially converted, section-by-section, into digital signals having differing word lengths (lₙ) and are thereafter associated with blocks of constant average word length (m) using first stores (3, 4), wherein selected data components from the sections of the data signals, in particular, a dc component (DC) and the most important ac components (ACₙ) including their appertaining addresses, are arranged in each of these blocks and wherein blocks having a smaller word length than the average word length are subsequently filled with data components (ACₓ) that are divided out from blocks having a larger than average word length, and, at the decoder end, the blocks are reconstituted into their original differing word lengths (ln) using second stores (9, 10), characterised in that, each of the blocks additionally contains an address information flag (FL) and an item of address pointer information (POI) which, during the decoding process following transfer and/or read errors, point to addresses in the second stores (9, 10) from which the data components (ACₓ), that are divided out from blocks having a larger than average word length, can be reconstituted and used for the decoding process.

2. Method in accordance with Claim 1, characterised in that, the digital signals include coded coefficients of a DCT.

3. Method in accordance with Claim 2, characterised in that, the blocks of constant average word length contain an item of information (I) as to the type of DCT coefficients that are included in the digital signals for the instantaneous block.

4. Method in accordance with any one or more of the Claims 1 to 3, characterised in that, the blocks, which include or are without ac components from other blocks, are appropriately marked by the address information flag (FL).

5. Method in accordance with any one or more of the Claims 1 to 4, characterised in that, the blocks, which include or are without ac components from other blocks, contain appropriately separated, calculated address pointer items of information (POIᵢ, POIⱼ), wherein the indices (i, j) of these separate items of address pointer information are respectively incremented by the value "1" during the coding of a corresponding type of block.

6. Coder for a method in accordance with any one or more of the Claims 1 to 5, which comprises:
- a coding circuit (1) which converts items of data, section-by-section, into digital signals having differing word lengths (lₙ);
- a subsequently connected multiplexer (2) which forms blocks of constant average word length (m) by means of subsequently connected first storage means (3, 4), wherein selected data components from the sections of the data signals - in particular, a dc component (DC) and the most important ac components (ACₙ) including their appertaining addresses - are stored in the first storage means for each of these blocks and wherein blocks having a smaller word length than the average word length are then filled with data components (ACₓ) that are divided out from blocks having a larger than average word length;
- a demultiplexer (5) connected subsequently of the storage means which packets the items of data appertaining to a respective block and forwards them on to a data channel (6),
characterised by:
- a circuit for calculating address pointers (13) which is fed by the first storage means and controls the multiplexer and the demultiplexer and which supplies an address information flag (FL) and an item of address pointer information (POI) to the first storage means for each block.

7. Decoder for a method in accordance with any one or more of the Claims 1 to 5, which comprises:
- a decoding circuit (7) connected subsequently of a data channel (6) for separating blocks of data;
- a subsequently connected multiplexer (8) which, together with subsequently connected storage means (9, 10), reconstitutes the data blocks into their original differing word lengths (ln);
- a demultiplexer (11) connected subsequently of the storage means which packets the items of data appertaining to a respective block and forwards them on to a variable length decoder (12) at whose output the items of data corresponding to the source data for the coding process are available,
characterised by:
- a circuit for calculating address pointers (14) which controls the multiplexer and the demultiplexer and supplies items of address pointer information (POI) to the storage means for each of the blocks, wherein the decoder circuit (7) decodes address pointers from the incoming data stream and forwards items of address pointer information and address information flags (FL) to the circuit for calculating the address pointers (14).

## Revendications

1. Procédé pour la transmission et/ou l'enregistrement de données où, au niveau du codeur, les données sont d'abord transformées segment par segment en signaux numériques d'une longueur de mot variable (Iₙ), puis affectées à des blocs de longueur moyenne constante (m) à l'aide de premières mémoires (3, 4), sachant que certaines composantes des données choisies dans les segments des signaux numériques, et notamment une composante fixe (DC) et les composantes variables essentielles (ACₙ), sont disposées dans chacun desdits blocs, et sachant en outre que les blocs dont la longueur est inférieure à la longueur de mot moyenne sont remplis à l'aide de composantes de données (AC_{X}) prélevées dans les blocs dont la longueur est supérieure à la longueur de mot moyenne, et qu'au niveau du décodeur, lesdits blocs sont récupérés dans leur longueur initiale variable (Iₙ) à l'aide de secondes mémoires (9, 10), procédé **caractérisé en ce** que chacun desdits blocs comprend en outre un indicateur d'adresse (FL) et une information de pointeur d'adresse (POI), qui, à la suite d'erreurs de transmission et/ou de lecture lors du décodage, indiquent les adresses dans lesdites secondes mémoires (9, 10) où les composantes de données (ACₓ) prélevées dans les blocs d'une longueur supérieure à la longueur de mot moyenne, peuvent être récupérées puis utilisées pour le décodage.

2. Procédé selon la revendication 1 **caractérisé en ce** que les signaux numériques incluent des coefficients codés provenant d'une transformation cosinus discrète.

3. Procédé selon la revendication 2 **caractérisé en ce** que les blocs de longueur constante moyenne comprennent une information (I) précisant les types de coefficients de transformation cosinus discrète contenus dans les signaux numériques pour chacun des blocs concernés.

4. Procédé selon l'une quelconque ou plusieurs des revendications 1 à 3 **caractérisé en ce** que l'indicateur d'adresse (FL) sert à marquer de manière adéquate les blocs avec ou sans composantes variables importés d'autres blocs.

5. Procédé selon l'une quelconque ou plusieurs des revendications 1 à 4 **caractérisé en ce** que les blocs avec ou sans composantes provenant d'autres blocs, comportent des informations de pointeur d'adresse (POIᵢ, POIⱼ) dont les indices (i, j) sont incrémentés d'une valeur de '1' lors du codage d'un certain type de bloc.

6. Codeur pour un procédé selon l'une quelconque ou plusieurs des revendications 1 à 5, intégrant :
- un circuit de codage (1) transformant les données segment par segment en signaux numériques de longueur de mot variable (Iₙ) ;
- un multiplexeur (2) monté en aval, qui forme des blocs de longueur moyenne constante (m) à l'aide de première mémoires (3, 4), sachant que des composantes de données choisies dans les segments des signaux numérique - notamment une composante fixe (DC) et les composantes variables essentielles (ACₙ) - sont enregistrées dans lesdites premières mémoires pour chacun de ces blocs, et sachant en outre que les blocs dont la longueur est inférieure à la longueur moyenne sont remplis à l'aide de composantes de données (ACₓ) prélevées dans les blocs dont la longueur est supérieure à la longueur moyenne ;
- un démultiplexeur (5) disposé en aval desdites mémoires, qui lie les données appartenant au bloc respectif et les transmet vers un canal de données (6) ;
codeur **caractérisé en ce** qu'il comporte :
- un circuit pour le calcul des pointeurs d'adresses (13), alimenté par lesdites premières mémoires, qui commande le multiplexeur et le démultiplexeur et fournit aux premières mémoires un indicateur d'adresse (FL) et une information de pointeur d'adresse (POI) pour chacun des blocs.

7. Décodeur pour un procédé selon l'une quelconque ou plusieurs des revendications 1 à 5, intégrant :
- un circuit de décodage (7) prévu en aval du canal de données (6) pour séparer des données d'un bloc ;
- un multiplexeur (8) disposé en aval et permettant, en association avec des mémoires en aval (9, 10), de récupérer des blocs de données avec leur longueur de mot variable initiale (lₙ) ;
- un démultiplexeur (11) prévu à la suite desdites mémoires, qui lie les données appartenant au bloc respectif et les transmet vers un décodeur de longueur variable (12) dont la sortie fournit des données correspondant aux données de source lors du codage ;
décodeur **caractérisé en ce** qu'il comporte :
- un circuit pour le calcul des pointeurs d'adresses (14) qui commande le multiplexeur et le démultiplexeur et transmet auxdites mémoires des informations de pointeurs d'adresses (POI), sachant que le circuit de décodage (7) décode les pointeurs d'adresses à partir du flux de données arrivant et retransmet des informations de pointeurs d'adresses et des indicateurs d'adresses (FL) vers le circuit pour le calcul des pointeurs d'adresses (14).
